**Europäisches Patentamt**

(19) **European Patent Office**

**Office européen des brevets**

(11) Numéro de publication: **0 203 848**
**B1**

(12) **FASCICULE DE BREVET EUROPEEN**

(45) Date de publication du fascicule du brevet:
**16.08.90**

(51) Int. Cl.⁵: **H01S 3/19**, H01L 33/00,
H01L 21/268

(21) Numéro de dépôt: **86401035.0**

(22) Date de dépôt: **14.05.86**

(54) Procédé de fabrication d'un laser à semiconducteur à géométrie à ruban et laser obtenu par ce procédé.

(30) Priorité: **21.05.85 FR 8507619**

(43) Date de publication de la demande:
**03.12.86 Bulletin 86/49**

(45) Mention de la délivrance du brevet:
**16.08.90 Bulletin 90/33**

(84) Etats contractants désignés:
**DE GB NL**

(56) Documents cités:
EP-A- 0 025 749
EP-A- 0 078 681
GB-A- 2 030 766
GB-A- 2 077 484
US-A- 3 936 322

NUCLEAR INSTRUMENTS & METHODS,
vol. 182/183, partie 2, avril-mai 1981, pages 699-703, North-Holland Publishing Co., Amsterdam, NL; Y. YUBA et al.: "Deep levels in implanted, pulse-laser-annealed GaAs"
IEEE JOURNAL OF QUANTUM ELECTRONICS, vol. 16, no. 8, août 1980, pages 898-901, IEEE, New York, US; A.J. SCHORR et al.: "Development of self-pulsations due to self-annealing of proton bombarded regions during aging in proton bombarded

(73) Titulaire: **Menigaux, Louis, 85 avenue des Tilleuls, F-91440 Bures sur Yvette(FR)**

(72) Inventeur: **Menigaux, Louis, 85 avenue des Tilleuls, F-91440 Bures sur Yvette(FR)**

(74) Mandataire: **Mongrédien, André et al, c/o BREVATOME 25, rue de Ponthieu, F-75008 Paris(FR)**

(56) Documents cités: (suite)
**stripe-geometry AlGaAs DH lasers grown by molecular beam epitaxy" 000**
**IEEE JOURNAL OF QUANTUM ELECTRONICS, vol. QE-11, no. 7, juillet 1975, pages 413-418, IEEE, New York, US; J.M. BLUM et al.: "Oxygen-implanted double-heterojunction GaAs/GaAlAs injection lasers"**

## Description

La présente invention a pour objet un procédé de fabrication d'un laser à semiconducteur à géométrie à ruban et un laser obtenu par ce procédé. Elle trouve une application en télécommunications optiques.

Le domaine technique de l'invention est celui des lasers à semiconducteurs dits à double hétérostructure. Une telle structure est constituée d'un empilement de couches semiconductrices déposées par épitaxie sur un substrat monocristallin. On trouve en général, en partant du substrat, une première couche de confinement, une couche active, (qui est responsable de l'émission de lumière), une seconde couche de confinement, une couche de contact et enfin une couche métallique. Le caractère de double hétérostructure vient de ce que la couche active est encadrée par deux couches dont la composition est différente de celle de la couche active.

Pour les lasers émettant entre 0,8 et 0,9 µm, les couches de confinement sont en alliage $Ga_{1-x}Al_xAs$, la couche active et le substrat étant en GaAs ; pour les lasers émettant entre 1,3 et 1,65 µm, les couches de confinement sont en $Ga_{1-x}In_xAs_{1-y}P_y$, la couche active et le substrat étant en InP.

Avec de telles structures, la densité de courant de seuil est de l'ordre de 1 kA/cm². Pour diminuer le courant de seuil proprement dit, on utilise différentes techniques permettant de délimiter un ruban actif de faible largeur. Ce ruban permet de confiner les porteurs de charges et de les diriger vers la zone active.

On connaît essentiellement trois techniques pour former ce ruban :

1°) par implantation de protons de part et d'autre d'une fenêtre, ce qui permet de créer deux régions fortement résistives, le courant ne passant que dans la fenêtre non implantée. Cette technique est décrite par exemple dans l'article de L.A. D'ASARO publié dans la revue "Journal of Luminescence" 7,310 (1973) et dans l'article de H.KAN, H.NAMIZAKI, M.ISHII and A.ITO publié dans la revue Appl. Phys. Lett. 27,138 (1975).

2°) par diffusion de zinc jusqu'à la zone active, à travers une fenêtre de silice. La zone diffusée présente une conduction plus grande que les régions qui la bordent. Cette technique est décrite par exemple dans l'article de H. YONEZU, I.SAKUMA, K.KOBAYASHI, T.KAMEJIMA, M.UENO et Y.NANNICHI, publié dans la revue Jpn. J. Appl. Phys. 12, 1585 (1973) et dans l'article de H.YONEZU, Y.MATSUMOTO, T.SHINOHARA, I.SAKUMA, T.SUZUDI, K.KOBAYASHI, R.LANG, Y.NANNICHI et I. HAYASHI publié dans la revue Jpn J. Appl. Phys. 16 209 (1977).

3°) par la réalisation d'un ruban enterré comme décrit dans l'article de T. TSUKADA publié dans "Jour. Appl. Phys." 45, 4899 (1974).

Bien que satisfaisantes à certains égards ces trois techniques présentent des inconvénients :

- la première, qui a recours à une implantation latérale de protons, n'améliore pas la conduction dans la zone d'injection des porteurs,
- la deuxième, qui procède par diffusion centrale, ne diminue pas la conduction des zones latérales,
- la troisième, enfin, met en œuvre une technologie très complexe, avec notamment une reprise d'épitaxie.

Le but de l'invention est de remédier à ces inconvénients. A cette fin, elle préconise un procédé qui combine les techniques d'implantation et de diffusion. Selon l'invention, on implante toute la surface de la structure laser avec une impureté dopante de type P (du béryllium par exemple) à une profondeur voulue. Ainsi, la couche superficielle devient électriquement isolante du fait de l'amorphisation totale ou quasitotale induite par la dose élevée d'impuretés introduites "à force" dans le semiconducteur. Puis, on recuit localement la zone implantée par focalisation d'une source d'énergie appropriée, ce qui restitue au matériau une structure cristalline propre à une bonne conduction électrique. Par déplacement de la source de rayonnement ou de la plaque support de la structure semiconductrice on donne la zone recuite la forme d'un ruban aux dimensions voulues.

Ainsi, sont combinés les avantages de l'implantation (qui conduit à un isolement dans les zones latérales) et de la diffusion, (qui conduit à une augmentation de la conduction dans la zone définissant le ruban).

La présente invention a également pour objet un laser obtenu par ce procédé. Ce laser est caractérisé par la présence d'un ruban cristallin dopé P entouré de zones latérales amorphes.

De toute façon, l'invention sera mieux comprise à la lecture de la description qui suit, d'un exemple de réalisation donné à titre explicatif et nullement limitatif. Cette description se réfère à des dessins annexés sur lesquels :

- la figure 1 représente, en coupe, une double hétérostructure après la première opération d'implantation,
- la figure 2 représente, selon la même coupe, la structure après recuit.

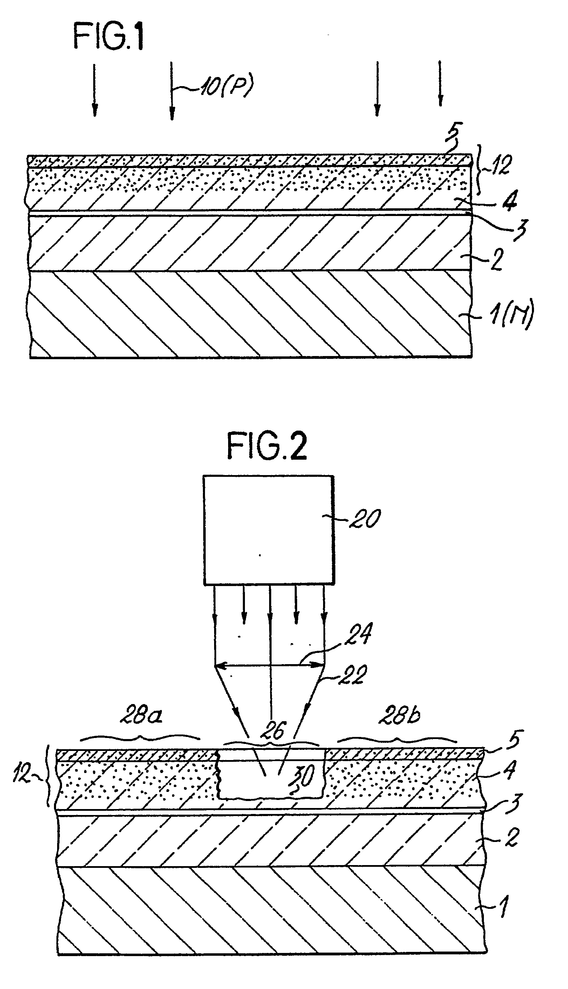

Sur la figure 1, est représentée une double hétérostructure comprenant un substrat 1 de type N, une première couche de confinement 2, une couche active 3, une seconde couche de confinement 4 et une couche de contact 5.

Conformément à l'invention, une implantation ionique, schématisée par les flèches 10, est effectuée à l'aide d'un dopant de type P, ce qui a pour effet de rendre amorphe une zone 12 (représentée en pointillé). Cette zone présente donc une forte résistivité électrique. Pour cette implantation, on peut utiliser par exemple du béryllium, implanté avec une énergie comprise entre 250 et 350 keV avec une dose comprise entre $5.10^{14}$ et $5.10^{15}$ cm². L'implantation doit être telle que la zone active 3 ne soit pas atteinte mais seulement approchée.

La seconde étape du procédé de l'invention est illustrée sur la figure 2. Au moyen d'une source 20, comme un laser ou un canon à électrons, on irradie la double hétérostructure obtenue après implantation par un faisceau énergétique convenablement focalisé par un moyen 24, pour échauffer les couches superficielles 4 et 5 sur une surface 26 de faible étendue.

L'échauffement produit une recristallisation du matériau dans un volume représenté par la zone 30, situé sous la surface 26. La profondeur de ce volume dépend de l'énergie fournie. Celle-ci est réglée pour que la recristallisation atteigne le bas de la zone implantée.

Cette recristallisation redonne au matériau sa conductivité, celle-ci étant en outre augmentée du fait de la présence du dopant P préalablement implanté. En déplaçant rectilignement soit la source 20, soit la double hétérostructure, on forme un ruban le long duquel la conductivité est excellente, ce ruban étant bordé par deux zones amorphes 28a, 28b où la résistivité est grande. On a donc ainsi obtenu un confinement des porteurs doublement efficace.

L'utilisation d'un laser comme source 20 semble particulièrement avantageuse. On peut utiliser un laser du type YAG,Nd$^{3+}$ pulsé délivrant une densité d'énergie moyenne de l'ordre de 0,1 Joule par cm$^2$. La vitesse de déplacement du point d'impact peut être de 0,01 cm/s.

On peut utiliser aussi un masque percé d'une ouverture rectiligne et éclairer le tout par une lampe.

Lorsque les opérations d'implantation et de recristallisation sont achevées, une couche métallique (non représentée sur les figures) est déposée sur l'ensemble pour être reliée à une source de courant.

Dans le cas d'une hétérostructure GaAs/GaAlAs, on peut avoir les compositions et les épaisseurs suivantes, pour les différentes couches, sans que l'invention soit limitée à ce cas :
Couche 1 : GaAs, épaisseur 100 µm,
Couche 2 : $Ga_{0,7}Al_{0,3}As$ dopé n ($10^{18}cm^{-3}$), épaisseur 1 µm,
Couche 3 : GaAs non dopé, épaisseur 0,15 µm,
Couche 4 $Ga_{0,7}Al_{0,3}As$ dopé p ($10^{18}cm^{-3}$), épaisseur 1 µm,
Couche 5 : $Ga_{0,9}Al_{0,1}As$ dopé p$^+$ ($5.10^{18}$ cm$^{-3}$), épaisseur 0,2 µm.

## Revendications

1. Procédé de fabrication d'un laser à semiconducteur dans lequel on forme une double hétérostructure sur un substrat (1) avec une première couche de confinement (2), une couche active (3), une seconde couche de confinement (4), une couche de contact (5), procédé dans lequel on constitue en outre un ruban où la conduction des porteurs de charges est favorisée par rapport aux zones qui l'entourent, ce procédé étant caractérisé par le fait que, pour constituer ce ruban :
   a) on implante dans la couche de contact (5) et dans une partie de la seconde couche de confinement (4) une impureté dopante de type P, avec une énergie et une dose telles que la zone implantée se trouve rendue amorphe,
   b) on irradie la structure implantée par un faisceau énergétique focalisé apte à recristalliser la zone amorphe le long d'un ruban.
2. Procédé selon la revendication 1, caractérisé en ce que le faisceau énergétique est un rayonnement optique focalisé (22), la double hétérostructure et le rayonnement étant déplacés rectilignement l'un par rapport à l'autre pour obtenir un ruban.

3. Laser susceptible d'être obtenu par le procédé de la revendication 1, ce laser comprenant une double hétérostructure sur un substrat (1) avec une première couche de confinement (2), une couche active (3), une seconde couche de confinement (4) et une couche de contact (5), ce laser possédant un ruban où la conduction des porteurs de charges est favorisée par rapport aux zones qui l'entourent, ce laser étant caractérisé par le fait que ce ruban est constitué par une zone cristalline (26) implantée par une impureté de type P, ce ruban étant entouré de zones implantées par la même impureté mais rendues amorphes par l'implantation.

## Claims

1. Process for the production of a semiconductor laser, in which a double heterostructure is formed on a substrate (1) with a first confinement layer (2), an active layer (3), a second confinement layer (4), and a contact layer (5) whereby a tape is also formed in which the conduction of the charge carriers is aided with respect to the zones surrounding the same, characterized in that for forming said tape:
   a) in the contact layer (5) and in part of the second confinement layer (4) is implanted a p-type doping impurity with an energy and dose such that the implanted zone is made amorphous,
   b) the implanted structure is irradiated with a focussed high energy beam able to recrystallize the amorphous zone along a tape.
2. Process according to claim 1, characterized in that the high energy beam is focussed optical radiation (22), the double heterostructure and radiation being displaced rectilinearly with respect to one another to obtain a tape.

3. Laser which can be obtained by the process of claim 1, the laser having a double heterostructure on a substrate (1) with a first confinement layer (2), an active layer (3), a second confinement layer (4) and a contact layer (5), said laser having a tape where the conduction of the charge carriers is aided with respect to the zones surrounding the same, wherein the tape is constituted by a crystalline zone (26) implanted by a p-type impurity, said tape being surrounded by zones implanted by the same impurity, but made amorphous by the implantation.

## Patentansprüche

1. Verfahren zur Herstellung eines Halbleiterlasers, in dem man auf einem Substrat (1) eine Doppelheterostruktur bildet mit einer ersten Begrenzungsschicht (2), einer aktiven Schicht (3), einer zweiten Begrenzungsschicht (4) und einer Kontaktschicht (5), wobei man bei dem Verfahren unter anderem einen Streifen herstellt, wo die Leitung der Ladungsträger im Vergleich zu den umgebenden Bereichen bevorzugt ist, wobei das Verfahren gekennzeichnet ist durch die Tatsache, daß man zur Herstellung dieses Streifens

a) in die Kontaktschicht (5) und in einen Teil der zweiten Begrenzungsschicht (4) eine Dotierungsverunreinigung vom P-Typ mit einer solchen Energie und Dosis implantiert, daß die implantierte Zone amorph wird und

b) die implantierte Struktur mit einem fokusierten Energiebündel bestrahlt, das in der Lage ist, die amorphe Zone entlang des Streifens zu rekristallisieren.

2. Verfahren nach Anspruch 1, dadurch gekennzeichnet, daß das Energiebündel ein fokusierter optischer Strahl (22) ist, wobei die Doppelheterostruktur und der Strahl in einem rechten Winkel voneinander versetzt sind, um einen Streifen zu erhalten.

3. Laser, der geeignet ist nach dem Verfahren nach Anspruch 1 hergestellt zu werden, wobei der Laser auf einem Substrat (1) eine Doppelheterostruktur aufweist mit einer ersten Begrenzungsschicht (2), einer aktiven Schicht (3), einer zweiten Begrenzungsschicht (4) und einer Kontaktschicht (5), wobei der Laser einen Streifen besitzt, wo die Leitung der Ladungsträger im Vergleich zu den umgebenden Bereichen bevorzugt ist, wobei der Laser gekennzeichnet ist durch die Tatsache, daß der Streifen aus einer kristallinen, mit Verunreinigungen des P-Typs implantierten Zone (26) besteht, wobei der Streifen von Zonen, die mit derselben Verunreinigung implantiert wurden, umgeben ist, die aber durch die Implantation amorph gemacht wurden.

# FIG.1

10(P)

5
12
4
3
2
1(M)

# FIG.2

20

24
22

28a          28b
26
12
5
4
3
2
1

30